Europäisches Patentamt

European Patent Office

Office européen des brevets

(19)

(11) **EP 1 008 183 B1**

(12) **EUROPÄISCHE PATENTSCHRIFT**

(45) Veröffentlichungstag und Bekanntmachung des Hinweises auf die Patenterteilung:
**30.11.2005  Patentblatt 2005/48**

(21) Anmeldenummer: **98954117.2**

(22) Anmeldetag: **04.09.1998**

(51) Int Cl.⁷: **H01L 27/112**, H01L 21/8246, G11C 17/10

(86) Internationale Anmeldenummer:
**PCT/DE1998/002618**

(87) Internationale Veröffentlichungsnummer:
**WO 1999/014808 (25.03.1999 Gazette 1999/12)**

(54) **SPEICHERZELLENANORDNUNG UND VERFAHREN ZU DEREN HERSTELLUNG**

MEMORY LOCATION ARRANGEMENT AND METHOD FOR PRODUCING THE SAME

CONFIGURATION DE CELLULE DE MEMOIRE ET SON PROCEDE DE FABRICATION

(84) Benannte Vertragsstaaten:
**DE**

(30) Priorität: **17.09.1997  DE 19740945**

(43) Veröffentlichungstag der Anmeldung:
**14.06.2000  Patentblatt 2000/24**

(73) Patentinhaber: **Infineon Technologies AG
81669 München (DE)**

(72) Erfinder:
• **RISCH, Lothar
  D-85579 Neubiberg (DE)**
• **RÖSNER, Wolfgang
  D-81739 München (DE)**
• **RAMCKE, Ties
  D-81739 München (DE)**
• **JACOBS, Hermann
  D-83052 Bruckmühl (DE)**

(74) Vertreter: **Epping - Hermann - Fischer
Ridlerstrasse 55
80339 München (DE)**

(56) Entgegenhaltungen:
**FR-A- 2 071 501        US-A- 3 863 231
US-A- 5 429 988        US-A- 5 840 608
US-A- 5 847 442**

• **DAVID, CHARLES A AND FELDMAN, BERNARD:
"High-speed fixed memories using large-scale
integrated resistor matrices" IEEE
TRANSACTIONS ON COMPUTERS., Bd. 17, Nr.
8, August 1968, Seiten 721-728, XP002092944
NEW YORK US**
• **PATENT ABSTRACTS OF JAPAN vol. 097, no.
002, 28. Februar 1997 & JP 08 255843 A (SONY
CORP), 1. Oktober 1996**

**Beschreibung**

Die Erfindung betrifft eine Speicherzellenanordnung, die unter anderem als Festwertspeicher geeignet ist. Als Festwertspeicher, auch Lesespeicher oder Read Only Memory bezeichnet, werden Speicheranordnungen bezeichnet, in die Daten in digitaler Form fest eingeschrieben sind.

Für große Datenmengen werden als Lesespeicher vielfach Kunststoffscheiben, sogenannte Compact Disc, verwendet, die mit Aluminium beschichtet sind. In der Beschichtung weisen sie zweierlei punktartige Vertiefungen auf, die den logischen Werten Null und Eins zugeordnet werden. In der Anordnung der Vertiefungen ist die Information digital gespeichert.

Zum Lesen der auf einer Compact Disc gespeicherten Daten werden die punktartigen Vertiefungen über eine Laserdiode und eine Photozelle abgetastet. Dazu ist ein Lesegerät mit bewegten Teilen erforderlich, die mechanischem Verschleiß unterworfen sind, die vergleichsweise viel Volumen benötigen und die nur einen langsamen Datenzugriff erlauben. Darüber hinaus ist das Lesegerät empfindlich gegen Erschütterungen und daher in mobilen Systemen nur begrenzt einsetzbar.

Ferner sind Speicher auf Halbleiterbasis bekannt (siehe zum Beispiel DE 44 34 725 C1). Diese Speicher auf Halbleiterbasis weisen als Speicherzellen MOS-Transistoren auf. Die Transistoren werden über die Gateelektrode, die mit einer Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet. Technisch wird die Speicherung von Null und Eins dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird oder ein MOS-Transistor mit höherer Einsatzspannung realisiert wird. Die höhere Einsatzspannung des MOS-Transistors kann durch entsprechende Implantation im Kanalgebiet oder durch eine höhere Gateoxiddichte erzielt werden.

Ferner sind Halbleiterspeicher vorgeschlagen worden, die als Speicherzellen Dioden aufweisen, die jeweils zwischen Wort- und Bitleitung geschaltet sind (siehe zum Beispiel C. de Graaf et al., IEDM 1996, Seite 189). Da die Dioden aber im elektrischen Verhalten gegenüber den Transistoren nachteilig sind, haben sich diese Konzepte in Produkten nicht durchgesetzt.

Speicher auf Halbleiterbasis erlauben einen wahlfreien Zugriff auf die gespeicherte Information. Die zum Lesen der Information erforderliche elektrische Leistung ist deutlich kleiner als bei einem Lesegerät mit einem mechanischen Laufwerk. Da zum Lesen der Information kein mechanisches Laufwerk benötigt wird, entfallen der mechanische Verschleiß und die Empfindlichkeit gegenüber Erschütterungen. Diese Speicher sind daher auch für mobile Systeme einsetzbar. Wegen des erforderlichen MOS-Transistors pro Speicherzelle sind sie jedoch in ihrer Herstellung technologisch aufwendig.

Der Erfindung liegt das Problem zugrunde, eine Speicherzellenanordnung anzugeben, die mit reduziertem technologischen Aufwand herstellbar ist. Darüber hinaus soll ein Verfahren zu deren Herstellung angegeben werden.

Dieses Problem wird durch eine Speicherzellenanordnung gemäß Anspruch 1 sowie durch ein Verfahren zu deren Herstellung gemäß Anspruch 3 gelöst. Weitere Ausgestaltungen der Erfindung gehen aus den weiteren Ansprüchen hervor.

Die Speicherzellenanordnung weist untereinander im wesentlichen parallel verlaufende Wortleitungen und untereinander im wesentlichen parallel verlaufende Bitleitungen auf. Die Wortleitungen verlaufen dabei quer zu den Bitleitungen. Die Wortleitungen können sowohl oberhalb als auch unterhalb der Bitleitungen verlaufen. Zwischen Wortleitungen und Bitleitungen sind Widerstände geschaltet, die hochohmiger als die Wortleitungen und die Bitleitungen sind. Die Bitleitungen sind jeweils mit einem Leseverstärker verbunden, über den das Potential an der jeweiligen Bitleitung auf ein Referenzpotential regelbar ist und an dem ein Ausgangssignal abgreifbar ist.

In dieser Speicherzellenanordnung werden die logischen Werte Null und Eins dadurch realisiert, daß Widerstände mit zweierlei Widerstandswert für die beiden verschiedenen logischen Werte realisiert werden oder daß für den einen der logischen Werte ein Widerstand, für den anderen der logischen Werte kein Widerstand hergestellt wird. In dem Fall, in dem nur für einen der logischen Werte ein Widerstand hergestellt wird, sind demnach entsprechend der gespeicherten Information nur ein Teil der Bitleitungen mit einem Teil der Wortleitungen über einen Widerstand verbunden.

In dieser Speicherzellenanordnung sind Wortleitungen und Bitleitungen miteinander verbunden. Die Speicherzellenanordnung kann dennoch ausgelesen werden, da die Bitleitungen über den Leseverstärker jeweils auf ein Referenzpotential regelbar sind. Die Bitleitungen werden zum Beispiel auf Erdpotential geregelt. Wird eine Wortleitung ausgewählt durch Anlegen eines Signals, während alle anderen Wortleitungen mit Referenzpotential, zum Beispiel Erdpotential verbunden sind, so ist das Ausgangssignal des Leseverstärkers abhängig von dem Widerstand, über den die Wortleitung mit der Bitleitung verbunden ist. Dieser Widerstand kann unendlich sein für den Fall, daß einer der logischen Werte dadurch realisiert wird, daß kein Widerstand vorhanden ist.

Vorzugsweise enthält der Leseverstärker einen rückgekoppelten Operationsverstärker. Wird der invertierende Eingang des Operationsverstärkers mit der Bitleitung verbunden, der nicht invertierende Eingang mit Erdpotential, und wird der Ausgang über einen Rückkopplungswiderstand mit dem invertierenden Eingang verbunden, so regelt der Operationsverstärker das Potential am invertierenden Eingang, das heißt an der Bitleitung, auf Null Volt. Aus dem Ausgangssignal des Operationsverstärkers und dem Rückkoppelwiderstand des Operationsverstärkers folgt dann der Wert des Widerstands zwischen der jeweiligen Bitleitung und der ausgewählten Wortleitung.

Vorzugsweise werden mehr Wortleitungen als Bitleitungen verwendet, da sich dadurch die erforderliche Anzahl der Leseverstärker reduziert.

Die Speicherzellenanordnung kann auf unterschiedliche Weise realisiert werden. Sie kann beispielsweise in Dünnschichttechnologie auf einer Trägerplatte zum Beispiel aus Glas, Silizium oder Metall realisiert werden. Vorzugsweise wird die Speicherzellenanordnung als Halbleiterschichtaufbau auf einem Halbleitersubstrat realisiert. Als Halbleitersubstrat ist zum Beispiel eine Siliziumscheibe oder ein SOI-Substrat geeignet. Die Wortleitungen und/oder Bitleitungen werden als streifenförmige Strukturen aus leitfähigem Material, zum Beispiel Metall, dotiertes Silizium und/oder Metallsilizid oder als streifenförmige dotierte Gebiete in der Oberfläche des-Substrats gebildet. Vorzugsweise werden sie gleichzeitig mit der Bildung einer Leiterbahnebene, zum Beispiel Gateebene oder Metallisierungsebene, hergestellt.

Die Verwendung eines Halbleitersubstrats hat den Vorteil, daß in dem Substrat Bauelemente der Peripherie, zum Beispiel der Leseverstärker, Ansteuerschaltungen oder ähnliches, integriert enthalten sein können.

Weiterhin kann die Speicherzellenanordnung in den beiden obersten Metallisierungslagen eines Halbleiterbauelements, welche im unteren Bereich unter anderem die Leseverstärker enthält, realisiert werden.

Die Herstellung der Speicherzellenanordnung erfolgt vorzugsweise in Halbleitertechnologie. Die Wortleitungen und Bitleitungen werden jeweils durch Schichtabscheidungen und anschließende Strukturierung oder durch Dotierung mit Hilfe photolithographischer Prozeßschritte gebildet. Die Widerstände werden vorzugsweise durch Ätzen eines Kontaktloches an den Kreuzungspunkten zwischen den betreffenden Wortleitungen und Bitleitungen und Bildung eines Widerstands in dem Kontaktloch erzeugt. Da durch diese Kontaktlochätzung und Bildung des Widerstandes die Programmierung der Speicherzellenanordnung erfolgt und es allgemein als vorteilhaft angesehen wird, diese Programmierung am Ende der Fertigung vorzunehmen, ist es vorteilhaft, die Kontaktlöcher unmittelbar vor der letzten Metallisierungsebene zu öffnen.

Die Kontaktlöcher können auch nach der Bildung von Bitleitungen und Wortleitungen geöffnet und geeignet aufgefüllt werden.

Im Hinblick auf das Ausleseverfahren der Daten ist es vorteilhaft, die Widerstände mit Widerstandswerten im Mega-Ohm-Bereich zu realisieren. Es liegt im Rahmen der Erfindung, die Widerstände mit einer isolierenden Tunnelschicht zu versehen. Als Tunnelschicht wird eine isolierende Schicht bezeichnet, die so dünn ist, daß Ladungsträger durch den quantenmechanischen Tunneleffekt diese Tunnelschicht überwinden können und so ein elektrischer Strom durch diese Tunnelschicht fließt. Tunnelschichten werden üblicherweise aus Oxiden, zum Beispiel $Al_2O_3$ oder $SiO_2$ gebildet. Der Widerstand umfaßt in diesem Fall die Tunnelschicht und eine leitfähige Schicht, zum Beispiel dotiertes Polysilizium, das den Anschluß zur zugehörigen Wort- bzw. Bitleitung darstellt. Alternativ können die Widerstände aus schwach dotiertem Polysilizium und/oder amorphem Silizium gebildet werden.

Zur Erhöhung der Packungsdichte ist es vorteilhaft, die Wortleitungen durch eine Spacertechnik zu bilden. Dazu wird zunächst eine Hilfsstruktur erzeugt, die streifenförmige Elemente aufweist. Eine leitfähige Schicht wird anschließend mit im wesentlichen konformer Kantenbedeckung gebildet. Durch anisotropes, zur Hilfsstruktur selektives Ätzen werden die Wortleitungen dann in Form von leitfähigen Spacern aus der leitfähigen Schicht gebildet. Die Abmessungen der Hilfsstrukturen sind durch die verwendete Photolithographie auf eine Breite und einen Abstand der streifenförmigen Elemente von jeweils F, das heißt einer minimal herstellbaren Strukturgröße in der jeweiligen Lithographie, beschränkt. Die leitfähigen Spacer bilden sich an beiden Flanken der streifenförmigen Elemente, so daß die Dichte der Wortleitungen um den Faktor 2 im Vergleich zur lithographisch erzielbaren Dichte erhöht wird.

Beim Auslesen der Speicherzellenanordnung mit i Bitleitungen und j Wortleitungen ergibt sich der Widerstand einer angesteuerten Wortleitung maximal aus der Parallelschaltung von i Widerständen mit Wert $R_{max}$ zu $R_{max}/i$. Wird nun für einen der logischen Werte ein Widerstand mit zum Beispiel 1 MΩ erzeugt, und beträgt auch der Rückkoppelwiderstand 1 MΩ, so ergibt sich bei einem Gesamtleckstrom von 1 nA ein Signal von 1 mV für den einen logischen Wert und von 1 V für den anderen logischen Wert, sofern die Wortleitung mit einem Signal von zum Beispiel 1 V ausgewählt wird. Der Widerstand der angesteuerten Wortleitung beträgt dann bei zum Beispiel 100 Bitleitungen mindestens 10 kΩ.

Im folgenden wird die Erfindung anhand von Ausführungsbeispielen, die in den Figuren dargestellt sind, näher erläutert.

Figur 1     zeigt eine Architektur für eine Speicherzellenanordnung, in der die logischen Werte Null und Eins durch unterschiedliche Widerstände realisiert sind.

Figur 2     zeigt einen Ausschnitt aus einer Speicherzellenanordnung, in der die logischen Werte Null und Eins durch Bildung keines Kontaktloches oder eines Kontaktloches mit einem Widerstand realisiert sind.

Figur 3    und 4 zeigt Herstellschritte zur Bildung einer Speicherzellenanordnung, die als Wortleitungen leitfähige Spacer aufweist.

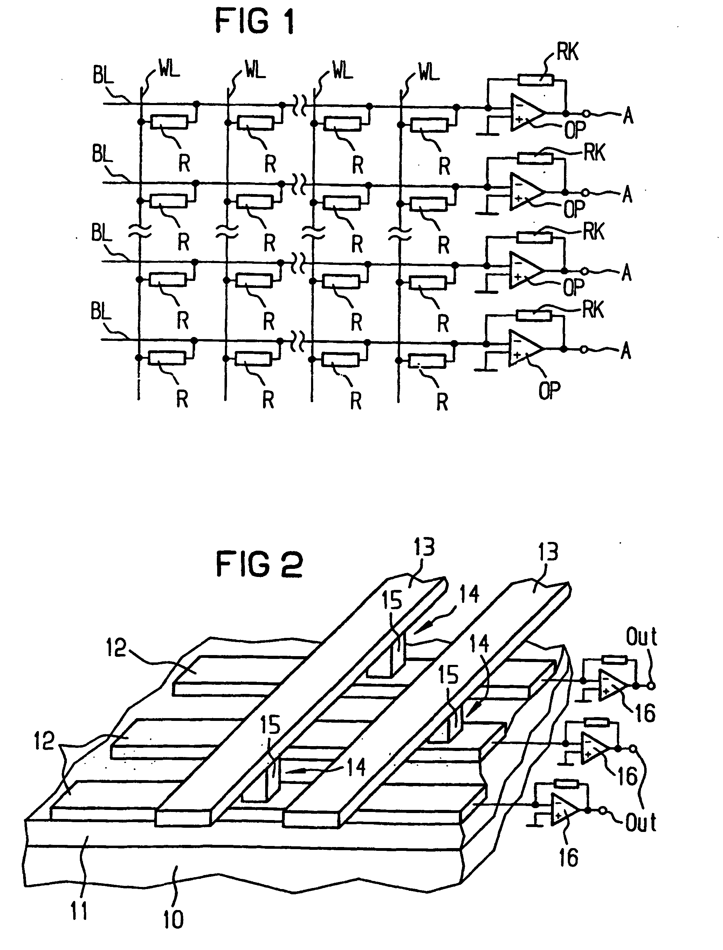

Eine Speicherzellenanordnung umfaßt im wesentlichen parallel verlaufende Wortleitungen WL und quer dazu verlaufende, untereinander im wesentlichen parallel verlaufende Bitleitungen BL (siehe Figur 1). Zwischen jeweils eine der Bitleitungen BL und eine der Wortleitungen WL ist ein Widerstand R geschaltet. Ein Teil der Widerstände R weist einen Widerstandswert von 1 Mega-Ohm auf, die übrigen Widerstände weisen einen Widerstandswert von 2 Mega-Ohm auf. Der Widerstandswert von 2 Mega-Ohm wird dem logischen Wert Null zugeordnet, der Widerstandswert von 1 Mega-Ohm dem logischen Wert Eins. Es sind 100 Bitleitungen BL und 10.000 Wortleitungen WL vorgesehen.

Jede der Bitleitungen BL ist mit dem invertierenden Eingang eines Operationsverstärkers OP verbunden. Der nicht invertierende Eingang des Operationsverstärkers OP ist mit Erdpotential verbunden. Der Operationsverstärkers OP ist rückgekoppelt und weist einen Rückkopplungswiderstand RK auf.

Zum Auslesen der in der Speicherzellenanordnung gespeicherten Information wird eine der Wortleitungen WL durch Anlegen eines Signals von zum Beispiel 1 Volt ausgewählt. Die übrigen Wortleitungen werden auf Erdpotential gelegt. Dadurch wird ein Strompfad zwischen der ausgewählten Wortleitung WL und jeder der Bitleitungen BL geschaltet. Da die Bitleitungen BL durch die Operationsverstärker OP jeweils auf 0 Volt geregelt werden, findet zwischen den Bitleitungen BL kein Stromfluß statt. Das Ausgangssignal, das jeweils am Ausgang A jedes der Operationsverstärker OP abgegriffen wird, ist ein Maß für den Widerstandswert des Widerstands R am Kreuzungspunkt der jeweiligen Bitleitung BL und der ausgewählten Wortleitung WL. Für das Ausgangssignal $V_{out}$ gilt:

$$V_{out} = 1V \cdot \frac{RK}{R + Rbl}$$

Dabei ist RK der Widerstandswert des Rückkoppelwiderstandes RK, R der Widerstandswert des Widerstandes R und Rbl der Widerstandswert der Bitleitung BL. Dieser Zusammenhang gilt, weil die Bitleitung BL auf 0 Volt geregelt wird und der Strom durch die Bitleitung BL über den Rückkoppelwiderstand RK fließt.

Ein Substrat 10 ist mit einer isolierenden Schicht 11 versehen. Das Substrat 10 ist zum Beispiel eine Siliziumscheibe oder die monokristalline Siliziumschicht eines SOI-Substrats. Die isolierende Schicht 11 enthält $SiO_2$ und weist eine Dicke von 100 nm auf (siehe Figur 2).

An der Oberfläche der isolierenden Schicht 11 sind Bitleitungen 12 angeordnet. Die Bitleitungen 12 sind jeweils streifenförmig und verlaufen untereinander im wesentlichen parallel. Sie weisen eine Länge von 10 mm und eine Breite von 0,5 µm auf. Der Abstand zwischen benachbarten Bitleitungen 12 beträgt 0,5 µm. Die Bitleitungen 12 enthalten Aluminium oder Wolfram. Sie werden durch Abscheidung einer ganzflächigen Aluminiumschicht und anschließende Strukturierung unter Verwendung photolithographischer Prozeßschritte erzeugt. Vorzugsweise werden sie in einem Halbleiterprozeß gleichzeitig mit der Herstellung einer Metallisierungsebene gebildet.

Die Bitleitungen 12 werden mit einer Zwischenoxidschicht (nicht dargestellt) bedeckt. An der Oberfläche der Zwischenoxidschicht, die eine Dicke von 650 nm aufweist und die aus $SiO_2$ gebildet wird, sind Wortleitungen 13 angeordnet. Die Wortleitungen 13 verlaufen quer zu den Bitleitungen 12. Die Wortleitungen 13 weisen eine Länge von 100 µm und eine Breite von 0,5 µm auf. Der Abstand benachbarter Wortleitungen 13 beträgt 0,5 µm. Die Wortleitungen werden aus Aluminium gebildet. Dazu wird eine Aluminiumschicht abgeschieden und mit Hilfe photolithographischer Prozeßschritte strukturiert. Vorzugsweise werden die Wortleitungen 13 gleichzeitig mit der Herstellung einer Metallisierungsebene in einem Halbleiterprozeß gebildet.

Zur Programmierung der Speicherzellenanordnung werden nach Fertigstellung der Bitleitungen 12 und der darüberliegenden Zwischenoxidschicht an denjenigen Kreuzungspunkten zwischen einer der Wortleitungen 13 und einer der Bitleitungen 12, an denen ein logische Eins gespeichert wird, Kontaktlöcher 14 geöffnet. Dazu wird eine photolithographisch erzeugte Maske verwendet, die an den Orten für die Kontaktlöcher 14 Öffnungen aufweist. Die Kontaktlöcher 14 werden durch anisotropes Ätzen zum Beispiel mit $CHF_3$, $CF_4$, Ar gebildet.

Anschließend werden in den geöffneten Kontaktlöchern 14 Widerstände 15 gebildet. Dieses erfolgt zum Beispiel durch Bildung einer $Al_2O_3$-Schicht in einer Schichtdicke von 2 nm, die eine Tunneloxidschicht darstellt. Anschließend wird das Kontaktloch 14 mit Aluminium aufgefüllt. Alternativ werden die Widerstände 15 mit schwach dotiertem Polysilizium oder schwach dotiertem amorphem Silizium mit einer Dotierstoffkonzentration von $10^{14}$ $cm^{-3}$ aufgefüllt. Eine weitere Möglichkeit zur Bildung der Widerstände 15 besteht in der Auffüllung der Kontaktlöcher 14 mit dotiertem Polysilizium mit einer Dotierstoffkonzentration im Bereich $10^{14}$ $cm^{-3}$ und anschließender Bildung einer $SiO_2$-Schicht durch thermische Oxidation mit einer Schichtdicke von 2 nm. Die $SiO_2$-Schicht wirkt als Tunneloxidschicht. Die Widerstände 15 weisen einen Widerstandswert von 1 MΩ auf.

Die Bitleitungen 12 werden jeweils mit dem invertierenden Eingang eines Operationsverstärkers 16 verbunden. Der nicht invertierende Eingang des Operationsverstärkers 16 wird jeweils auf Erdpotential gelegt. Der Operationsverstärker 16 wird rückgekoppelt verschaltet.

Im Betrieb der Speicherzellenanordnung wird das Potential an den Bitleitungen 12 durch den Operationsverstärker 16 jeweils auf Erdpotential geregelt. Wie anhand von Figur 1 erläutert ist das Ausgangssignal der Operationsverstärkers 16 somit ein Maß für den Widerstandswert, der zwischen einer ausgewählten Wortleitung 13 und der zugehörigen Bitleitung 12 wirksam ist. Da in diesem Ausführungsbeispiel für den logischen Wert Null kein Kontaktloch 14 geöffnet und kein Widerstand 15 gebildet wird, beträgt der Widerstand zwischen den Wortleitungen 13 und den Bitleitungen 12, an deren Kreuzungspunkt eine Null gespeichert ist, unendlich. In diesem Fall ist das Ausgangssignal annähernd Null. Diese Ausführungsform hat daher den Vorteil, daß die logischen Werte Null und Eins leicht zu unterscheiden sind.

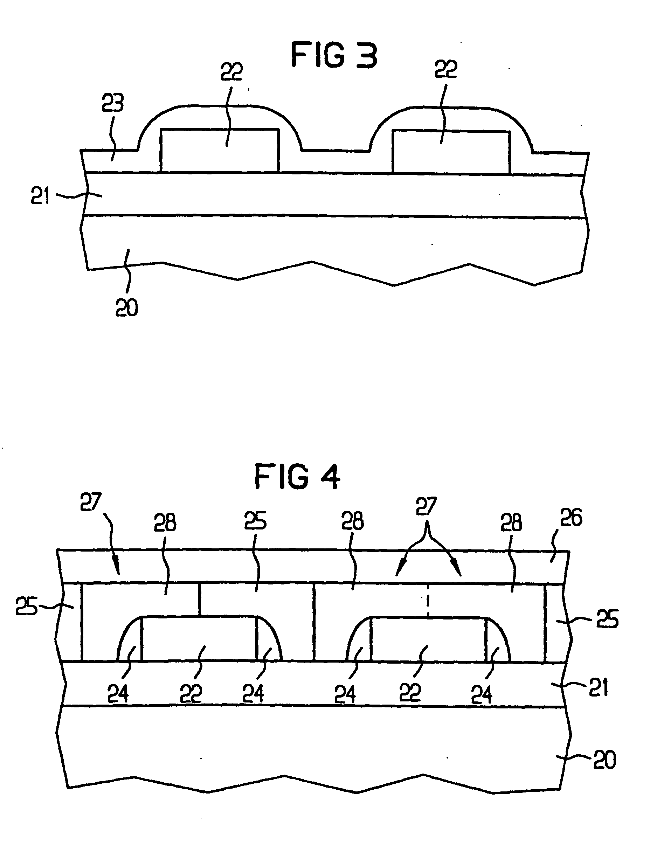

Auf der Oberfläche eines Substrats 20 ist eine isolierende Schicht 21 angeordnet (siehe Figur 3). Das Substrat 20 ist zum Beispiel eine monokristalline Siliziumscheibe oder die monokristalline Siliziumschicht eines SOI-Substrats. Die isolierende Schicht 21 enthält $SiO_2$ und weist eine Dicke von 100 nm auf. Auf der Oberfläche der isolierenden Schicht 21 werden streifenförmige Hilfsstrukturen 22 gebildet. Die streifenförmigen Hilfsstrukturen 22 werden zum Beispiel ebenfalls aus $SiO_2$ durch anisotropes Ätzen mit Hilfe einer photolithographisch gebildeten Maske erzeugt. Die streifenförmigen Hilfsstrukturen 22 weisen eine Breite von 0,5 $\mu$m und einen Abstand von 0,5 $\mu$m auf. Diese Breite entspricht der minimalen Strukturbreite F in einer 16 M-Technologie.

Es wird ganzflächig eine leitfähige Schicht 23 mit im wesentlichen konformer Kantenbedeckung abgeschieden. Die leitfähige Schicht 23 wird zum Beispiel in einer Dicke von 150 nm gebildet. Die leitfähige Schicht 23 enthält zum Beispiel dotiertes Polysilizium und Metallsilizid. Das dotierte Polysilizium weist dabei eine Dotierstoffkonzentration von $10^{21}$ cm$^{-3}$ auf. Als Metallsilizid ist zum Beispiel $TiSi_2$ oder $CoSi_2$ geeignet.

Durch anisotropes Ätzen selektiv zu $SiO_2$ zum Beispiel mit $Cl_2$, $CF_4$ werden an den Flanken der Hilfsstrukturen 22 leitfähige Spacer 24 gebildet, die als Wortleitungen verwendet werden (siehe Figur 4). In einem Halbleiterprozeß werden die leitfähigen Spacer 24 vorzugsweise gleichzeitig mit anderen leitfähigen Spacern aus demselben Material, die in der Halbleiterschaltung zum Beispiel als Gateelektroden oder sonstige Anschlüsse verwendet werden, gebildet.

Anschließend wird eine Zwischenoxidschicht 25 gebildet, die eine Dicke von 400 nm aufweist. Die Zwischenoxidschicht 25 wird zum Beispiel aus Borphosphorsilikatglas gebildet und weist eine im wesentlichen ebene Oberfläche auf. Die Zwischenoxidschicht 25 überdeckt die Hilfsstrukturen 22 und die leitfähigen Spacer 24.

Zur Programmierung der Speicherzellenanordnung werden anschließend analog wie anhand von Figur 2 geschildert Kontaktlöcher 27 geöffnet an denjenigen Kreuzungspunkten zwischen einer der Bitleitungen 26 und einer der leitfähigen Spacer 24, die als Wortleitungen dienen, an denen eine logische Eins gespeichert wird. Da auf eine Strecke mit 2 F Länge zwei leitfähige Spacer 24 kommen und die Kontaktlöcher 27 mit Abmessungen von minimal F gebildet werden können, fallen benachbarte Kontaktlöcher 27 zusammen. Dieses ist in Figur 4 durch die gepunktete Linie angedeutet.

Zur Bildung von Widerständen 28 werden die Kontaktlöcher 27 anschließend aufgefüllt. Als Material für die Widerstände 28 sind dieselben Materialien verwendbar, die in dem anhand von Figur 2 beschriebenen Ausführungsbeispiel erläutert wurden.

Auf die Oberfläche der Zwischenoxidschicht 25 und die aufgefüllten Kontaktlöcher 27 wird eine leitfähige Schicht zum Beispiel aus Aluminium abgeschieden und mit Hilfe photolithographischer Prozeßschritte strukturiert, um Bitleitungen 26 zu bilden. Die Bitleitungen 26 verlaufen quer zu den leitfähigen Spacern 24. Die Bitleitungen 26 verlaufen parallel zur zweiten Ebene.

Die Bitleitungen 26 werden, wie anhand von Figur 1 und 2 erläutert, jeweils mit dem invertierenden Eingang eines Operationsverstärkers verbunden. Die weitere Verschaltung des Operationsverstärkers und das Ausleseverfahren erfolgt analog wie anhand von Figur 1 und 2 erläutert.

**Patentansprüche**

**1.** Speicherzellenanordnung,

- bei der in einem Halbleiterschichtaufbau (10,11) parallel verlaufende Wortleitungen (13) und parallel verlaufende Bitleitungen (12) vorhanden sind, wobei die Wortleitungen (13) und die Bitleitungen (12) quer zueinander verlaufen und zwischen den Wortleitungen (13) und den Bitleitungen (12) eine isolierende Schicht angeordnet ist,

- bei der zwischen Wortleitungen (13) und Bitleitungen (12) Widerstände (15) geschaltet sind, die hochohmiger als die Wortleitungen (13) und die Bitleitungen (12) sind und die jeweils in einem Kontaktloch (14) angeordnet sind, das in der isolierenden Schicht an einem Kreuzungspunkt zwischen einer der Bitleitungen (12) und einer der Wortleitungen (13) zwischen der jeweiligen Bitleitung (12) und der jeweiligen Wortleitung (13) angeordnet ist,

- bei der die Bitleitungen (12) jeweils mit einem Leseverstärker (16) verbunden sind, über den das Potential an der jeweiligen Bitleitung (12) auf ein Referenzpotential regelbar ist und an dem ein Ausgangssignal abgreifbar ist und welcher einen rückgekoppelten Operationsverstärker (16) aufweist,

- bei der die Widerstände (15) erste Widerstände oder zweite Widerstände mit unterschiedlichen Widerstandswerten umfassen, wobei die ersten Widerstände einen ersten logischen Wert und die zweiten Widerstände einen zweiten logischen Wert repräsentieren,

- bei der die ersten oder zweiten Widerstände

  i) eine erste isolierende Tunnelschicht, insbesondere $Al_2O_3$ oder $SiO_2$, und
  ii) eine sich daran anschließende leitfähige Schicht, insbesondere dotiertes amorphes oder polykristallines Silizium,

umfassen.

2. Speicherzellenanordnung nach Anspruch 1, bei der die Anzahl der Wortleitunge (13) größer als die Anzahl der Bitleitungen (12) ist.

3. Verfahren zur Herstellung einer Speicherzellenanordnung,

- bei dem auf der Oberfläche eines Substrats (10) parallel verlaufende Wortleitungen (13) und eine parallel verlaufende Bitleitungen (12) und eine isolierende Schicht gebildet werden, wobei die Wortleitungen (13) quer zu den Bitleitungen (12) verlaufen und wobei die isolierende Schicht zwischen den Wortleitungen (13) und den Bitleitungen (12) angeordnet ist,

- bei dem an vorgegebenen Kreuzungspunkten zwischen Bitleitungen (12) und Wortleitungen (13) in der isolierenden Schicht Kontaktlöcher (14) geöffnet werden, die jeweils zwischen einer der Bitleitungen (12) und einer der Wortleitungen (13) angeordnet sind, in denen jeweils ein Widerstand (15) realisiert wird, der zwischen die jeweilige Bitleitung (12) und die jeweilige Wortleitung (13) geschaltet ist und der hochohmiger als die Bitleitunge (12) und die Wortleitungen (13) ist,

- bei dem Leseverstärker (16) erzeugt werden, die mit jeweils einer der Bitleitungen (12) verbunden werden, über die das Potential an der jeweiligen Bitleitung (12) auf ein Referenzpotential regelbar ist und an dem ein Ausgangssignal abgreifbar ist.

- bei dem die Widerstände (15) durch Bildung

  i) einer ersten isolierenden Tunnelschicht, insbesondere $Al_2O_3$ oder $SiO_2$, und
  ii) einer sich daran anschließenden leitfähigen Schicht, insbesondere dotiertes amorphes oder polykristallines Silizium,

in den Kontaktlöchern (14) hergestellt werden.

4. Verfahren nach Anspruch 3,

- bei dem zur Bildung der Wortleitungen (13) unächst eine Hilfsstruktur (22) erzeugt wird, die streifenförmige Elemente auf-weist,

- bei dem eine leitfähige Schicht (23) mit konformer Kantenbedeckung erzeugt wird,

- bei dem durch anisotropes, zur Hilfsstruktur (22) selektives Ätzen die Wortleitungen (13) in Form von leitfähigen Spacern (24) aus der leitfähigen Schicht (23) gebildet werden.

**Claims**

1. Memory cell arrangement,

- in which, in a semiconductor layer structure (10, 11), word lines (13) running parallel and bit lines (12) running parallel are provided, the word lines (13) and the bit lines (12) running transversely with respect to one another and an insulating layer being arranged between the word lines (13) and the bit lines (12),

- in which resistors (15) having a higher resistance than the word lines (13) and the bit lines (12) are connected between the word lines (13) and the bit lines (12) and are each arranged in a contact hole (14) which is arranged in the insulating layer at a crossover point between one of the bit lines (12) and one of the word lines (13) between the respective bit line (12) and the respective word line (13),

- in which the bit lines (12) are each connected to a sense amplifier (16) by means of which the potential on the respective bit line (12) can be regulated to a reference potential and at which an output signal can be picked off and which has a feedback operational amplifier (16).

- in which the resistors (15) comprise first resistors or second resistors with different resistances, the first resistors representing a first logic value and the second resistors representing a second logic value,

- in which the first or second resistors comprise

i) a first insulating tunnel layer, in particular Al$_2$O$_3$ or SiO$_2$, and
ii) an adjoining conductive layer, in particular doped amorphous or polycrystalline silicon.

**2.** Memory cell arrangement according to Claim 1, in which the number of word lines (13) is greater than the number of bit lines (12).

**3.** Method for fabricating a memory cell arrangement,

- in which word lines (13) running parallel and bit lines (12) running parallel and an insulating layer are formed on the surface of a substrate (10), the word lines (13) running transversely with respect to the bit lines (12) and the insulating layer being arranged between the word lines (13) and the bit lines (12),
- in which contact holes (14) which are each arranged between one of the bit lines (12) and one of the word lines (13) are opened at predetermined crossover points between bit lines (12) and word lines (13) in the insulating layer, in each of which contact holes a resistor (15) is realized which is connected between the respective bit line (12) and the respective word line (13) and has a higher resistance than the bit lines (12) and the word lines (13),
- in which sense amplifiers (16) are produced, which are connected to in each case one of the bit lines (12), by means of which the potential on the respective bit line (12) can be regulated to a reference potential and at which an output signal can be picked off,
- in which the resistors (15) are fabricated by forming

    i) a first insulating tunnel layer, in particular Al$_2$O$_3$ or SiO$_2$, and
    ii) an adjoining conductive layer, in particular doped amorphous or polycrystalline silicon

in the contact holes (14).

**4.** Method according to Claim 3,

- in which, in order to form the word lines (13), first of all an auxiliary structure (22) having strip-type elements is produced,
- in which a conductive layer (23) with conformal edge coverage is produced,
- in which, by means of anisotropic etching which is selective with respect to the auxiliary structure (22), the word lines (13) are formed in the form of conductive spacers (24) from the conductive layer (23).

**Revendications**

**1.** Configuration de cellules de mémoire,

- dans laquelle, dans une structure (10, 11) stratifiée de semi-conducteur, il y a des lignes (13) de mots qui s'étendent parallèlement et des lignes (12) de bits qui s'étendent parallèlement, les lignes (13) de mots et les lignes (12) de bits s'étendant transversalement les unes aux autres, et une couche isolante est disposée entre les lignes (13) de mots et les lignes (12) de bits,
- dans laquelle il est monté, entre les lignes (13) de mots et les lignes (12) de bits, des résistances (15) qui ont une plus grande valeur ohmique que les lignes (13) de mots et les lignes (12) de bits et qui sont disposées respectivement dans un trou (14) de contact qui est disposé dans la couche isolante entre la ligne (12) de bits et la ligne (13) de mots respectives, en un point d'intersection entre l'une des lignes (12) de bits et l'une des lignes (13) de mots,
- dans laquelle les lignes (12) de bits sont reliées respectivement à un amplificateur (16) de lecture par lequel le potentiel sur la ligne (12) de bits respective peut être réglé à un potentiel de référence et sur lequel un signal de sortie peut être prélevé et qui a un amplificateur (16) opérationnel couplé en réaction,
- dans laquelle les résistances (15) comprennent des premières résistances et des deuxièmes résistances ayant des valeurs différentes, les premières résistances représentant une première valeur logique et les deuxièmes résistances représentant une deuxième valeur logique,
- dans laquelle les premières ou les deuxièmes résistances comprennent

    i) une première couche isolante formant tunnel, notamment en Al$_2$O$_3$ ou en SiO$_2$, et
    ii) une couche conductrice s'y raccordant, notamment en silicium polycristallin ou amorphe dopé.

**2.** Configuration de cellules de mémoire suivant la revendication 1,
dans laquelle le nombre des lignes (13) de mots est plus grand que le nombre des lignes (12) de bits.

**3.** Procédé de production d'une configuration de cellules de mémoire,

- dans lequel on forme à la surface d'un substrat (10) des lignes (13) de mots s'étendant parallèlement et des lignes (12) de bits s'étendant parallèlement et une couche isolante, les lignes (13) de mots s'étendant transversalement aux lignes (12) de bits et la couche isolante étant disposée entre les lignes (13) de mots et les lignes (12) de bits,

- dans lequel on ouvre en des points d'intersection prescrits entre des lignes (12) de bits et des lignes (13) de mots, dans la couche isolante, des trous (14) de contact qui sont disposés respectivement entre l'une des lignes (12) de bits et l'une des lignes (13) de mots dans lesquelles est réalisée respectivement une résistance (15) qui est montée entre la ligne (12) de bits respective et la ligne (13) de mots respective et qui a une valeur ohmique plus grande que les lignes (12) de bits et que les lignes (13) de mots,

- dans lequel on produit des amplificateurs (16) de lecture qui sont reliés à respectivement l'une des lignes (12) de bits et par lesquels le potentiel sur la ligne (12) de bits respectif peut être réglé à un potentiel de référence et sur lequel on peut prélever un signal de sortie,

- dans lequel il est ménagé dans les trous (14) de contact les résistances (15) par formation

    i) d'une première couche isolante formant tunnel, notamment en $Al_2O_3$ ou en $SiO_2$, et
    ii) d'une couche conductrice s'y raccordant, notamment en silicium polycristallin ou amorphe dopé.

4. Procédé suivant la revendication 3,

- dans lequel, pour former les lignes (13) de mots, on produit d'abord une structure (22) auxiliaire qui a des éléments en forme de bandes,

- dans lequel on produit une couche (23) conductrice à recouvrement des bords conforme,

- dans lequel on forme, par attaque anisotrope sélective pour la structure (22) auxiliaire, les lignes (13) de mots sous la forme d'espaceurs (24) conducteurs à partir de la couche (23) conductrice.

# FIG 1

# FIG 2

## FIG 3

## FIG 4